# EUROPEAN PATENT APPLICATION

(11) **EP 4 653 666 A2**
(43) Date of publication of application: **26.11.2025**
(21) Application number: 25193887.4
(22) Date of filing: 02.03.2020
(51) Int. Cl.: F01D 5/28

(54) **NICKEL-BASED SUPERALLOY AND HEAT TREATMENT FOR SALT ENVIRONMENTS**

(30) Priority: 05.04.2019 US 201962829821 P
(62) Divisional of application: 20160383.4
(71) Applicant: RTX Corporation, Farmington, CT 06032 (US)
(72) Inventor: CETEL, Alan D., West Hartford, 06117 (US); SHAH, Dilip M., Glastonbury, 06033 (US)
(74) Representative: Dehns

(57) **Abstract**

An alloy has, by weight: nickel (Ni) as a largest constituent; 6.7% to 7.5% chromium; 1.8% to 2.3% molybdenum; 4.75% to 10.3% cobalt; 5.3% to 5.9% aluminum; 2.8% to 3.2% rhenium; 3.7% to 7.3% tungsten; and 6.0% to 9.0% tantalum.

## Description

### BACKGROUND

The disclosure relates to gas turbine engines. More particularly, the disclosure relates to alloy selection and crystalline orientation for gas turbine engine components.

Gas turbine engine hot section components are commonly formed of alloys, typically nickel- or cobalt-based superalloys. Many components, such as blades are formed of single-crystal (SX) alloys. In such single-crystal components, essentially the entire component is formed of a single continuous crystal lattice. Typically, the orientation of that lattice is predetermined to achieve desired properties of the component. The orientation may be assured by use of a grain starter or other casting techniques.

By way of example, U.S. Pat. No. 4,605,452 of Gemma and Dierberger identifies face centered cubic (FCC) single-crystal gas turbine blades wherein the [110] crystal axis is tangent to the blade airfoil surface in a critical crack-prone region just behind the leading edge of the airfoil at about 40-80% of the airfoil span. U.S. Pat. No. 6,074,602 (the '602 patent) of Wukusick and Buchakjian, Jr., identifies a further single-crystal alloy. Table I (discussed below) includes comparative data from an alloy of the '602 patent among others.

### SUMMARY

One aspect of the disclosure involves an alloy comprising, by weight: nickel (Ni) as a largest constituent; 6.7% to 7.5% chromium; 1.8% to 2.3% molybdenum; 4.75% to 10.3% cobalt; 5.3% to 5.9% aluminum; 2.8% to 3.2% rhenium; 3.7% to 7.3% tungsten; and 6.0% to 9.0% tantalum.

A further embodiment of any of the foregoing embodiments may additionally and/or alternatively include the alloy comprising, by weight: nickel (Ni) as said largest constituent; 6.8% to 7.2% chromium; 1.8% to 2.2% molybdenum; 4.9% to 10.2% cobalt; 5.35% to 5.7% aluminum; 2.9% to 3.1% rhenium; 3.8% to 7.2% tungsten; and 6.1% to 8.9% tantalum.

A further embodiment of any of the foregoing embodiments may additionally and/or alternatively include, by weight, one or more of: a titanium content, if any, being no more than 0.50%; a boron content, if any, being no more than 0.01%; a yttrium content, if any, being no more than 0.02%; a sulfur content, if any, being no more than 5ppm; a hafnium content, if any being no more than 0.50%; a silicon content, if any, being no more than 0.50%; and a carbon content, if any, being no more than 0.10%.

A further embodiment of any of the foregoing embodiments may additionally and/or alternatively include, by weight, one or more of: a sulfur content, if any, being no more than 1ppm; a hafnium content being 0.050% to 0.15%; a silicon content, if any, being no more than 0.30%; and a carbon content, if any, being no more than 0.10%.

A further embodiment of any of the foregoing embodiments may additionally and/or alternatively include, by weight: a combined content, if any, of elements other than nickel, chromium, cobalt, aluminum, rhenium, tungsten, tantalum, molybdenum, if any, sulfur, if any, hafnium, if any, silicon, if any, and carbon, if any, being no more than 1.0%.

A further embodiment of any of the foregoing embodiments may additionally and/or alternatively include, by weight: a combined content, if any, of elements other than nickel, chromium, cobalt, aluminum, rhenium, tungsten, tantalum, molybdenum, if any, sulfur, if any, hafnium, if any, silicon, if any, and carbon, if any, being no more than 0.75%.

A further embodiment of any of the foregoing embodiments may additionally and/or alternatively include, by weight: an individual content, if any, of every element other than nickel, chromium, cobalt, aluminum, rhenium, tungsten, tantalum, molybdenum, if any, sulfur, if any, hafnium, if any, silicon, if any, and carbon, if any, being no more than 0.50%.

A further embodiment of any of the foregoing embodiments may additionally and/or alternatively include, by weight: an individual content, if any, of every element other than nickel, chromium, cobalt, aluminum, rhenium, tungsten, tantalum, molybdenum, if any, sulfur, if any, hafnium, if any, silicon, if any, and carbon, if any, being no more than 0.40%.

A further embodiment of any of the foregoing embodiments may additionally and/or alternatively include, by weight: the combined content of chromium, cobalt, and aluminum being 17.0% to 23.0%.

A further embodiment of any of the foregoing embodiments may additionally and/or alternatively include, by weight: the combined content of chromium, cobalt, and aluminum being 17.5% to 22.5%.

A further embodiment of any of the foregoing embodiments may additionally and/or alternatively include, by weight: the combined content of tungsten and tantalum being 8.0% to 14.0%.

A further embodiment of any of the foregoing embodiments may additionally and/or alternatively include, by weight: the combined content of tungsten and tantalum being 12.0% to 13.0%.

A further embodiment of any of the foregoing embodiments may additionally and/or alternatively include, by weight: the combined content of rhenium, tungsten, and tantalum being 9.0% to 16.5%.

A further embodiment of any of the foregoing embodiments may additionally and/or alternatively include, by weight: the combined content of rhenium, tungsten, and tantalum being 10.0% to 15.5%.

A further embodiment of any of the foregoing embodiments may additionally and/or alternatively include, by weight: yttrium, lanthanum, and/or cerium up to 0.05% combined.

A further embodiment of any of the foregoing embodiments may additionally and/or alternatively include the alloy having one to-all of: an average 1500F/90ksi salt rupture life of at least 450 hours; and an average 1500F/100 ksi salt rupture life of at least 150 hours; an average 1800F/36 ksi air rupture life of at least 150 hours; and an average 1850F/38 ksi air rupture life of at least 40 hours.

A further embodiment of any of the foregoing embodiments may additionally and/or alternatively include the alloy having one-to-all of: an average 1500F/90ksi salt rupture life of at least 300 hours; and an average 1500F/100 ksi salt rupture life of at least 100 hours; an average 1800F/36 ksi air rupture life of at least 140 hours; and an average 1850F/38 ksi air rupture life of at least 38 hours.

A further embodiment of any of the foregoing embodiments may additionally and/or alternatively include the alloy in single-crystal (SX) form.

A further embodiment of any of the foregoing embodiments may additionally and/or alternatively include a turbine blade comprising a substrate formed of the alloy (e.g. the alloy as herein described, the treated alloy as herein described, or the alloy resulting from the methods herein described).

A further embodiment of any of the foregoing embodiments may additionally and/or alternatively include the turbine blade comprising: an attachment root; an airfoil extending from a proximal end to a tip; and a platform between the airfoil and the attachment root.

A further embodiment of any of the foregoing embodiments may additionally and/or alternatively include the turbine blade further comprising: a thermal barrier coating atop the substrate at least along the airfoil.

A further embodiment of any of the foregoing embodiments may additionally and/or alternatively include the thermal barrier coating not being along the root and platform underside.

A further embodiment of any of the foregoing embodiments may additionally and/or alternatively include the alloy, heat treated by a method comprising: a solution heat treat for a period of at least 4.0 hours; and after the solution heat treat, an intermediate heat treatment at 1950F to 2075F for 3.5 hours to 4.5 hours followed by a final aging precipitation heat at a temperature of 1575F to 1675F for a period of 4.0 hours to 32.0 hours.

A further embodiment of any of the foregoing embodiments may additionally and/or alternatively include the precipitation heat being at a temperature of 1575F to 1675F for a period of 8.0 hours to 32.0 hours.

A further embodiment of any of the foregoing embodiments may additionally and/or alternatively include the solution heat treat being at least 20F over solvus.

A further embodiment of any of the foregoing embodiments may additionally and/or alternatively include a method for using the alloy, the method comprising: a solution heat treat for a period of at least 4.0 hours; and after the solution heat treat, a final aging precipitation heat at a temperature of 1575F to 1675F for a period of 4.0 hours to 32.0 hours. A further embodiment of any of the foregoing embodiments may additionally and/or alternatively include a method for heat-treating an alloy comprising solution heat-treating the alloy as herein described for a period of at least 4.0 hours; and performing a final aging precipitation heat at a temperature of 1575F to 1675F for a period of 4.0 hours to 32.0 hours, preferably after the solution heat treat.

A further embodiment of any of the foregoing embodiments may additionally and/or alternatively include the method being effective to improve rupture performance in salt environments relative to a pure precipitation heat treat.

A further embodiment of any of the foregoing embodiments may additionally and/or alternatively include the method being effective to improve rupture performance in salt environments relative to a solution heat treat of 2.0 hours or less followed by precipitation heat treat otherwise under like conditions.

A further embodiment of any of the foregoing embodiments may additionally and/or alternatively include the method comprising an intermediate heat treatment at 1950F to 2075F for 3.5 hours to 4.5 hours, preferably after the solution heat treat.

A further embodiment of any of the foregoing embodiments may additionally and/or alternatively include the method comprising the precipitation heat being at a temperature of 1575F to 1675F for a period of 8.0 hours to 32.0 hours.

A further embodiment of any of the foregoing embodiments may additionally and/or alternatively include the method comprising the solution heat treat being at least 20F over solvus.

The details of one or more embodiments are set forth in the accompanying drawings and the description below. Other features, objects, and advantages will be apparent from the description and drawings, and from the claims.

### BRIEF DESCRIPTION OF THE DRAWINGS

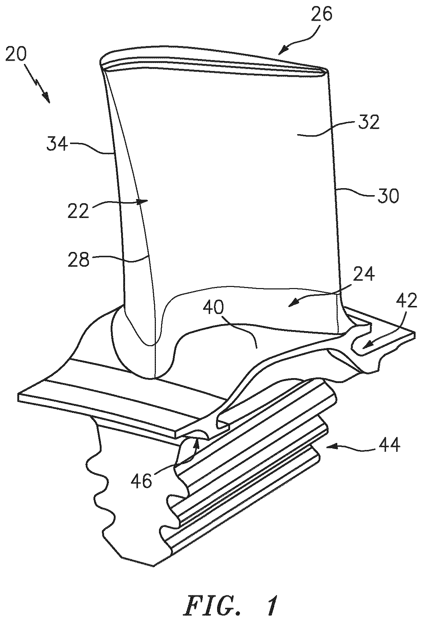

FIG. 1 is a view of a turbine blade.

Like reference numbers and designations in the various drawings indicate like elements.

### DETAILED DESCRIPTION

In FIG. 1, an engine turbine element 20 is illustrated as a blade having an airfoil 22 which extends between an inboard end 24, and an opposing outboard end 26 (e.g., at a free tip), a distance therebetween extending substantially in the engine radial direction. The airfoil also includes a leading edge 28 and an opposing trailing edge 30. A pressure side 32 and an opposing suction side 34 extend between the leading edge 28 and trailing edge 30.

The airfoil inboard end 24 is disposed at the outboard surface 40 of a platform 42. An attachment root 44 extends radially inward from the underside 46 of the platform.

The root 44 has an inner diameter (ID) end or face 48, an upstream axial end 50, a downstream axial end 52, and first and second lateral sides 54 and 56, respectively. The root 44 is complementary to a disk slot (not shown). When fully seated in the disk slot, the faces 50 and 52 may face exactly forward/upstream and rearward/downstream in the engine frame of reference. Depending on disk configuration (slot orientation), the sides may extend parallel to the engine centerline between the axial ends (root having a rectangular footprint/section) or may extend skew (root having a non-right parallelogram footprint) such as in the illustrated example.

The turbine blade is cast of a high temperature alloy, namely a single-crystal Ni-based superalloy discussed below.

The blade may also have a thermal barrier coating (TBC, e.g., one or more layer ceramic atop of one or more layer bondcoat) system along at least a portion of the airfoil.

The blade may have an internal cooling passageway system (not shown) extending from one or more inlets along a root to a plurality of outlets (along or mostly along the airfoil and platform surfaces).

Stress corrosion cracking (SCC) has been a concern in commercial engine turbine blades. Atmospheric salt and pollution appear to be contributing factors. A particular area of SCC is along platform undersides of high pressure turbine (HPT) blades.

A number of alloys were conceived as potentially offering improved resistance to stress corrosion cracking, particularly in salt environments. Table I shows test data for ten candidate alloys (Ex. 1-10) and four prior art alloys (Prior Art 1-4). Of the examples, Ex. 7, 9, and 10 show particular benefits discussed below.

Table I lists the post-solutioning heat treatments used. For example, "2050F/4+1975F/4+1650F/4" indicates 2050° Fahrenheit for four hours followed by 1975° Fahrenheit for four hours followed by 1650° Fahrenheit for four hours. The solutioning involved heat treatment at or above the alloy gamma prime solvus temperatures for 4.0 hours in the 2350° to 2375° Fahrenheit range.

Rupture tests were performed on creep-rupture specimens with nominal 0.125 inch gauge diameters tested isothermally at 1500F with constant load and low melting eutectic salt mixture brushed on the gauge section every 100 hours. The salt was a quaternary system of sodium, magnesium, potassium, and calcium sulfates with a melting point of about 1200F (e.g., 1175F-1225F or 1195F to 1205F). The salt represents an approximately equal blend of two ternary examples from the cited Du article below (rows 5 and 6 of Table 4 of the Du article). The air rupture test was performed in a furnace drawing in ambient laboratory air; whereas the salt rupture test was performed in a similar arrangement although salt was brushed on the gauge section periodically. Such salt and test procedure may be used as a reference in the tests of the claims below. Alternative reference salts are disclosed in BORNSTEIN, NORMAN S. "Reviewing sulfidation corrosion-Yesterday and today", Journal of Materials (Jom), November, 1996, pages 37-39, Volume 48, Issue No. 11, Springer, Heidelberg, Germany and DU, H., "Thermodynamic assessment of the K2SO4-Na2SO4-MgSO4-CaSO4 system", Journal of Phase Equilibria, January 1, 2000, pages 6-18,Volume 21, Issue No. 1, Springer, Heidelberg, Germany. The disclosures of said Bornstein and Du articles are incorporated by reference in their entireties herein as if set forth at length. Similar relative behavior of alloys and heat treatments would be expected when tested with the Bornstein and Du salts to the results obtained herein.

Two factors to be considered from the tests are absolute rupture life and consistency in rupture life. Because of the relatively close compositions of the examples and prior art, what would otherwise be a statistically insignificantly small sample size of one alloy (e.g., one or two tests) allows a statistically significant conclusion to be made when such small test numbers of many slightly different alloys are considered. Thus, running only two tests each of two alloys would not be statistically significant if one alloy had a 300-hour test life and a 250-hour test life while the other had a 300-hour test life and a 50-hour test life. But, such two-test per alloy data becomes significant when one looks a greater number of alloys. From such data one may statistically significantly determine a compositional range associated with the long life and/or consistent performance. In this case, a compositional range around Ex. 7, 9, and 10 is indicated as having an advantageous combination of life and consistency.

In contrast, consider Ex. 1, 2 and 3 where Cr levels below 6.75% produced instances of lower rupture lives in salted creep testing.

In Table I, the three targeted alloys (Ex. 7, 9, and 10) have significant amounts of the elements Ni, Cr, Mo, W, Ta, Al, Co, and Re. As far as other elements, Ti, C, B, Y, and/or Hf can be added in small amounts to benefit alloy properties. S should be kept as low as possible to benefit oxidation resistance. Small Si additions will also benefit oxidation resistance. Combined Y + Hf + B + Si additions should be maintained below 0.40% to achieve high levels of alloy incipient melting temperature. In terms of individual contents, in exemplary ranges one-to-all of a titanium content, if any, is no more than 0.50%; a boron content, if any, is no more than 0.01%; a yttrium content, if any, is no more than 0.02%; a sulfur content, if any, is no more than 5ppm or no more than 1ppm; a hafnium content, if any is no more than 0.50% or is in the range of 0.050% to 0.15%; a silicon content, if any, is no more than 0.50% or 0.30%; and a carbon content, if any, is no more than 0.10%, by weight.

In various examples, a combined weight content, if any, of elements other than nickel, chromium, cobalt, aluminum, rhenium, tungsten, tantalum, molybdenum, if any, sulfur, if any, hafnium, if any, silicon, if any, and carbon, if any, is no more than 1.0% or 0.75% or 0.50% or 0.40%.

In various examples, the combined weight content of chromium, cobalt, and aluminum is 17.0% to 23.0% or 17.5% to 22.5% or 20.0% to 22.0%.

In terms of heat treatment, from Table I it can be further determined that an advantageous heat treatment involves full or close to full gamma prime solutioning at temperatures at or above 2375F, followed by intermediate heat treatments at 2050F and or 1975F for 4 hours with a final PHT aging heat treatment at 1650F for 4 hours.

As a further refinement, Table III involves exploration of heat treatment parameters with the Prior Art 3 alloy. Solution heat treat is at a temperature between solvus and incipient melting point. At commercial scale to have an effective heat treat, solutioning may be at a temperature of at least 20F over solvus or at least 25F or at least 30F. At the other end, to avoid errors (risk of incipient melting due to process variation), a target solution heat treat may be in the range of not more than 40F below incipient melting or not more than 35F or not more than 30F or not more than 25F.

The Prior Art 3 alloy has a 2440F incipient melting temperature and a 2370F solvus temperature. Exemplary solution heat treat is 2400F up to the incipient melting temperature. At commercial scale to avoid errors, a target solution heat treat may be in the range of 2380F to 2415F. Times of 30 minutes, 4 hours, and 20 hours are given. High consistency is seen at 20 hours. Alternative exemplary lower ends on ranges other than 4 hours are 6 hours and 8 hours. Much above 20 would seem to offer little benefit for cost.

Several pure precipitation heat treatments (PHT) are compared with several solution heat treatments. The latter are followed by a two-stage final heat treatment. In the same salt tests as those of Table I, it is seen that the increasing alloy homogenization by increasing the time at the solution heat treatment temperature reduces variability and increases average life. The post-solutioning final aging heat treatment (a precipitation heat treat (PHT)) also plays a significant role in increasing both the minimum and average rupture life in salt tests. Increasing both the PHT temperature to 1600F and the time to 32 hours produces the highest creep-rupture life in a salt environment.

When transferring this Prior Art 3 experience to the other alloys, adjustments may be made for differences in solutioning temperature and incipient melting point. For example, Examples 7, 9, and 10 have lower solvus and incipient meting temperatures which would have corresponding lower target heat treatment temperatures while preserving times.

Alloys to be used in turbine blade applications require good high temperature creep-rupture strength in an air environment. Key Table I examples also show good high temperature creep-rupture life as shown in testing conducted at 1800F/36ksi and 1850F/38ksi. Although lives are not as good as those in the alloy of Prior Art 3, they are adequate to meet service turbine blade requirements. We infer that these good lives can be maintained by insuring that total W + Ta + Re content stays in the range of 9.0 to 16.5% by weight. Total W + Ta content may more narrowly stay in the range of 12.0% to 13.0% by weight or more broadly 8.0% to 14.0% (with life compromise at the low end).

**Table I**

| Alloy Rupture Tests (Salt and Air) Up to Two Tests at each of Two Conditions per Heat Treat | | | | | | | | | | | | | | | | | | |
|---|---|---|---|---|---|---|---|---|---|---|---|---|---|---|---|---|---|---|
| Tested Alloy | Elemental Weight Percentage | | | | | | | | | | | | | Post-Solution Heat Treat (Temp/Hours) | Test (hours) | | | |
| | | | | | | | | | | | | | | | Salt Rupture | | Air Rupture | |
| | Ni | Cr | Ti | Mo | W | Ta | Al | Co | Re | Hf | C | B | Y | | 1500F-90ksi | 1500F-100ksi | 1800F-36ksi | 1850F-38ksi |
| Ex. 1 | Bal | 6.03 | 0 | 1.94 | 6 | 6.33 | 5.68 | 10.02 | 2.93 | 0.09 | 0.03 | <0.01 | <0.001 | 1975F/4+1500 F/8 | 214.8 | 0.6 | 188.3 | 42.3 |
| | | | | | | | | | | | | | | | 15.3 | 3 | 188.9 | 40.8 |
| | | | | | | | | | | | | | | 2050F/4+1975 F/4+1650F/4 | 240.5 | 3.3 | 202.4 | 43.3 |
| | | | | | | | | | | | | | | | 226.9 | 0.8 | 214.7 | 47.7 |
| | | | | | | | | | | | | | | 1975F/4+1650 F/4 | 235.6 | 105.5 | | |
| | | | | | | | | | | | | | | | 296 | 101.4 | | |
| Ex. 2 | Bal | 6.45 | 0 | 1.93 | 5.89 | 6.27 | 5.65 | 10.04 | 2.99 | 0.09 | 0.03 | <0.01 | <0.001 | 1975F/4+1500 F/8 | 1.2 | 0.6 | 193.7 | 49.8 |
| | | | | | | | | | | | | | | | 239.2 | 3.4 | 198.3 | 40.6 |
| | | | | | | | | | | | | | | 2050F/4+1975 F/4+1650F/4 | 230.5 | 115.3 | 159.1 | 51.7 |
| | | | | | | | | | | | | | | | 117.5 | 1.2 | 191.7 | 46.7 |
| | | | | | | | | | | | | | | 1975F/4+1650 F/4 | 341.6 | 116.9 | | |
| | | | | | | | | | | | | | | | 299.2 | 93.5 | | |
| Ex. 3 | Bal | 6.73 | 0 | 1.94 | 5.97 | 6.3 | 5.62 | 9.97 | 3.03 | 0.09 | 0.03 | <0.01 | <0.001 | 1975F/4+1500 F/8 | 255.9 | 0.7 | 232.8 | 54.4 |
| | | | | | | | | | | | | | | | 2.3 | 2.9 | 281.4 | 52.2 |
| | | | | | | | | | | | | | | 2050F/4+1975 F/4+1650F/4 | 441.3 | 95.6 | 275.8 | 52.8 |
| | | | | | | | | | | | | | | | 205.9 | 108.7 | 246.2 | 56.2 |
| | | | | | | | | | | | | | | 1975F/4+1650 F/4 | 416.2 | 40.8 | | |
| | | | | | | | | | | | | | | | 351 | 214.3 | | |
| Ex. 4 | Bal | 7.55 | 0 | 1.92 | 5.94 | 6.33 | 5.63 | 10 | 2.99 | 0.09 | 0.03 | <0.01 | <0.001 | 1975F/4+1500 F/8 | 298.8 | 124.9 | 182.1 | 39.9 |
| | | | | | | | | | | | | | | | 405.8 | 114.8 | 186.5 | 41.5 |
| | | | | | | | | | | | | | | 2050F/4+1975 F/4+1650F/4 | 205.1 | 134.8 | 195.5 | 37.8 |
| | | | | | | | | | | | | | | | 90.5 | 115.1 | 186.3 | 41.1 |
| | | | | | | | | | | | | | | 1975F/4+1650 F/4 | 114.5 | 195.5 | | |
| | | | | | | | | | | | | | | | 579.4 | 145.9 | | |
| Ex. 5 | Bal | 7.94 | 0 | 1.95 | 6.02 | 6.28 | 5.61 | 10 | 2.98 | 0.1 | 0.03 | <0.01 | <0.001 | 1975F/4+1500 F/8 | 363.9 | 113.2 | 136.4 | 32.2 |
| | | | | | | | | | | | | | | | 468.1 | 127.0 | 140.7 | |
| | | | | | | | | | | | | | | 2050F/4+1975 F/4+1650F/4 | 233.8 | 132.6 | 140.1 | 36.6 |
| | | | | | | | | | | | | | | | 376.9 | 150.9 | 142.7 | 34.8 |
| | | | | | | | | | | | | | | 1975F/4+1650 F/4 | 207.3 | 115.3 | | |
| | | | | | | | | | | | | | | | 483.5 | 160.8 | | |
| Ex. 6 | Bal | 6.97 | 0 | 1.93 | 5.95 | 6.28 | 5.61 | 7.55 | 3.02 | 0.09 | 0.03 | <0.01 | <0.001 | 1975F/4+1500 F/8 | 297.4 | 95.5 | 202.0 | 43.1 |
| | | | | | | | | | | | | | | | 385.3 | 0.7 | 188.4 | 42.5 |
| | | | | | | | | | | | | | | 2050F/4+1975 F/4+1650F/4 | 231.5 | 133.3 | 167.5 | 41.6 |
| | | | | | | | | | | | | | | | 206.1 | 90.6 | 180.8 | |
| | | | | | | | | | | | | | | 1975F/4+1650 F/4 | 114.8 | 128.0 | | |
| | | | | | | | | | | | | | | | 188.9 | 186.6 | | |
| Ex. 7 | Bal | 6.88 | 0 | 1.95 | 5.94 | 6.25 | 5.57 | 5.06 | 3.06 | 0.09 | 0.03 | <0.01 | <0.001 | 1975F/4+1500 F/8 | 322.1 | 140.1 | 163.6 | 42.1 |
| | | | | | | | | | | | | | | | 356.2 | 115.2 | 196.4 | |
| | | | | | | | | | | | | | | 2050F/4+1975 F/4+1650F/4 | 455.7 | 144.1 | 149.6 | 40.4 |
| | | | | | | | | | | | | | | | 348.8 | 97.0 | 165.3 | 41.9 |
| | | | | | | | | | | | | | | 1975F/4+1650 F/4 | 533.7 | 138.9 | | |
| | | | | | | | | | | | | | | | 496.6 | 208.1 | | |
| Ex. 8 | Bal | 5.99 | 0 | 2.07 | 5.97 | 6.31 | 5.6 | 7.56 | 3.05 | 0.09 | 0.03 | <0.01 | <0.001 | 1975F/4+1500 F/8 | 256.8 | 106.2 | 194.4 | 43.3 |
| | | | | | | | | | | | | | | | 232.0 | 10.1 | 186.7 | 48.4 |
| | | | | | | | | | | | | | | 2050F/4+1975 F/4+1650F/4 | 255.3 | 107.1 | 209.8 | 51.1 |
| | | | | | | | | | | | | | | | 230.5 | 51.8 | 169.5 | 44.0 |
| | | | | | | | | | | | | | | | 245.6 | 1.5 | | |
| | | | | | | | | | | | | | | 1975F/4+1650 F/4 | 210.8 | 132.6 | | |
| Ex. 9 | Bal | 7.0 | 0 | 2.0 | 4.0 | 8.8 | 5.6 | 10.1 | 3.0 | 0.11 | 0.03 | <0.01 | <0.001 | 1975F/4+1500 F/8 | 682.2 | | 251.9 | |
| | | | | | | | | | | | | | | 2050F/4+1975 F/4+1650F/4 | 803.3 | | | |
| Ex. 10 | Bal | 7.1 | 0 | 2.1 | 7.0 | 6.2 | 5.4 | 10.0 | 3.0 | 0.11 | 0.03 | <0.01 | <0.001 | 1975F/4+1500 F/8 | 430.2 | | 299.2 | |
| | | | | | | | | | | | | | | 2050F/4+1975 F/4+1650F/4 | 490.0 | | | |
| | | | | | | | | | | | | | | | 237.1 | | | |
| Prior Art 1 | Bal | 8 | 1.5 | 2 | 8 | 6 | 5 | 5 | 0 | | | | | 1975F/4+1550 F/24 | 234.3 | | | |
| | | | | | | | | | | | | | | | 227.8 | | | |
| Prior Art 2 | Bal | 6.5 | 1 | 0.6 | 6 | 6.5 | 5.6 | 9 | 3 | | | | | 2085F/2+1600 F/20 | 0.1 | | | |
| | | | | | | | | | | | | | | | 71.9 | | | |
| | | | | | | | | | | | | | | | 206.5 | | | |
| Prior Art 3 | Bal | 5 | 0 | 1.9 | 5.9 | 8.9 | 5.65 | 10 | 2 | 0.03 | 0.03 | <0.01 | <0.001 | 1975F/4+1500 F/8 | 0.7 min* | | 306 | 85.0 |
| | | | | | | | | | | | | | | | 401 max | | | |
| | | | | | | | | | | | | | | 1975F/4+1600 F/32 | 92.6 min | | | |
| | | | | | | | | | | | | | | | 517 max | | | |
| Prior Art 4 | Bal | 7 | 0 | 1.5 | 5 | 6.5 | 6.2 | 7.5 | 3 | 0.15 | 0.05 | 0.004 | 0.02 | 1975F/4+1500 F/8 | 263.9 | | | |
| | | | | | | | | | | | | | | 2050F/4+1975 F/4+1650F/4 | 247.3 | | 150.0 | 45.0 |
| | | | | | | | | | | | | | | 2050F/4+1975 F/4+1650F/4 | 410.1 | | | |

| | | | | | | | | | | | | | | | | | | |
|---|---|---|---|---|---|---|---|---|---|---|---|---|---|---|---|---|---|---|
| Prior Art 3 involved many samples and only the min. and max values are listed. | | | | | | | | | | | | | | | | | | |

**Table II**

| Alloy Compositional Ranges | | | | | | | | | | | | |
|---|---|---|---|---|---|---|---|---|---|---|---|---|
| Range | Elemental Weight Percentage | | | | | | | | | | | |
| | Ni | Cr | Mo | W | Ta | Al | Co | Re | Hf | C | B | Y |
| Range 1A | Bal | 6.7-7.5 | 1.8-2.3 | 3.7-7.3 | 6.0-9.0 | 5.3-5.9 | 4.75-10.3 | 2.8-3.2 | 0.08-0.15 | 0.03 | <0.01 | <0.001 |
| Range 1B | Bal | 6.8-7.2 | 1.8-2.2 | 3.8-7.2 | 6.1-8.9 | 5.35-5.7 | 4.9-10.2 | 2.9-3.1 | 0.09-0.12 | | | |
| Range 2A | Bal | 6.7-7.2 | 1.8-2.1 | 5.75-6.25 | 6.0-6.5 | 5.4-5.7 | 4.75-5.25 | 2.9-3.2 | 0.08-0.12 | | | |
| Range 2B | Bal | 6.8-7.1 | 1.85-2.0 | 5.8-6.1 | 6.1-6.4 | 5.5-5.7 | 4.9-5.2 | 3.0-3.2 | 0.08-0.11 | | | |
| Range 3A | Bal | 6.8-7.2 | 1.8-2.2 | 3.7-4.3 | 8.7-9.0 | 5.4-5.8 | 9.8-10.3 | 2.9-3.2 | 0.09-0.13 | | | |
| Range 3B | Bal | 6.9-7.1 | 1.9-2.1 | 3.8-4.2 | 8.7-8.9 | 5.5-5.7 | 9.9-10.1 | 2.9-3.1 | 0.10-0.12 | | | |
| Range 4A | Bal | 6.8-7.3 | 1.9-2.3 | 6.8-7.3 | 6.0-6.5 | 5.3-5.6 | 9.8-10.2 | 2.9-3.2 | 0.09-0.13 | | | |
| Range 4B | Bal | 6.9-7.2 | 2.0-2.2 | 6.9-7.1 | 6.1-6.3 | 5.3-5.5 | 9.9-10.1 | 2.9-3.1 | 0.10-0.12 | | | |

**Table III**

| Effect of heat Treatment on Prior Art 3 Min. and Max. Rupture Life (Hours) in Salt at 1500F-90ksi | | | | | |
|---|---|---|---|---|---|
| Heat Treat Type | Heat Treat Parameters | Final Heat Treat (FHT)* | Number of Samples | Rupture Life (Hours) | |
| | | | | Min. | Max. |
| N/A (As-Cast) | N/A | Y | 3 | 1.1 | 236.0 |
| Precipitation | 1300F/24hrs | N/A | 8 | 0.3 | 94.3 |
| | 1500F/8hrs | N/A | 29 | 1.1 | 401.2 |
| | 1600F/8hrs | N/A | 30 | 0.8 | 522.7 |
| | 1600F/32hrs | N/A | 27 | 92.6 | 517.0 |
| Solution | 2400F/30min | Y | 2 | 130.1 | 340.2 |
| | 2400/4hrs | Y | 2 | 327.7 | 398.7 |
| | 2400F/20hrs | Y | 2 | 399 | 406.5 |

| | | | | | |
|---|---|---|---|---|---|
| * 1975F/4hrs + 1600F/32hrs | | | | | |

The use of "first", "second", and the like in the following claims is for differentiation within the claim only and does not necessarily indicate relative or absolute importance or temporal order. Similarly, the identification in a claim of one element as "first" (or the like) does not preclude such "first" element from identifying an element that is referred to as "second" (or the like) in another claim or in the description.

One or more embodiments have been described. Nevertheless, it will be understood that various modifications may be made. For example, when applied to an existing baseline configuration, details of such baseline may influence details of particular implementations. Accordingly, other embodiments are within the scope of the following claims.

Certain embodiments of the present disclosure are as follows:
1. An alloy comprising, by weight:
   nickel (Ni) as a largest constituent;
   6.7% to 7.5% chromium;
   1.8% to 2.3% molybdenum;
   4.75% to 10.3% cobalt;
   5.3% to 5.9% aluminum;
   2.8% to 3.2% rhenium;
   3.7% to 7.3% tungsten; and
   6.0% to 9.0% tantalum.
2. The alloy of embodiment 1 comprising, by weight:
   nickel (Ni) as said largest constituent;
   6.8% to 7.2% chromium;
   1.8% to 2.2% molybdenum;
   4.9% to 10.2% cobalt;
   5.35% to 5.7% aluminum;
   2.9% to 3.1% rhenium;
   3.8% to 7.2% tungsten; and
   6.1% to 8.9% tantalum.
3. The alloy of embodiment 1 wherein, by weight, one or more of:
   a titanium content, if any, is no more than 0.50%;
   a boron content, if any, is no more than 0.01%;
   a yttrium content, if any, is no more than 0.02%;
   a sulfur content, if any, is no more than 5ppm;
   a hafnium content, if any is no more than 0.50%;
   a silicon content, if any, is no more than 0.50%; and
   a carbon content, if any, is no more than 0.10%.
4. The alloy of embodiment 1 wherein, by weight, one or more of:
   a sulfur content, if any, is no more than 1ppm;
   a hafnium content is 0.050% to 0.15%;
   a silicon content, if any, is no more than 0.30%; and
   a carbon content, if any, is no more than 0.10%.
5. The alloy of embodiment 1 wherein, by weight:
   a combined content, if any, of elements other than nickel, chromium, cobalt, aluminum, rhenium, tungsten, tantalum, molybdenum, if any, sulfur, if any, hafnium, if any, silicon, if any, and carbon, if any, is no more than 1.0%.
6. The alloy of embodiment 1 wherein, by weight:
   a combined content, if any, of elements other than nickel, chromium, cobalt, aluminum, rhenium, tungsten, tantalum, molybdenum, if any, sulfur, if any, hafnium, if any, silicon, if any, and carbon, if any, is no more than 0.75%.
7. The alloy of embodiment 1 wherein, by weight:
   an individual content, if any, of every element other than nickel, chromium, cobalt, aluminum, rhenium, tungsten, tantalum, molybdenum, if any, sulfur, if any, hafnium, if any, silicon, if any, and carbon, if any, is no more than 0.50%.
8. The alloy of embodiment 1 wherein, by weight:
   an individual content, if any, of every element other than nickel, chromium, cobalt, aluminum, rhenium, tungsten, tantalum, molybdenum, if any, sulfur, if any, hafnium, if any, silicon, if any, and carbon, if any, is no more than 0.40%.
9. The alloy of embodiment 1 wherein, by weight:
   the combined content of chromium, cobalt, and aluminum is 17.0% to 23.0%.
10. The alloy of embodiment 1 wherein, by weight:
   the combined content of chromium, cobalt, and aluminum is 17.5% to 22.5%.
11. The alloy of embodiment 10 wherein, by weight:
   the combined content of tungsten and tantalum is 8.0% to 14.0%.
12. The alloy of embodiment 10 wherein, by weight:
   the combined content of tungsten and tantalum is 12.0% to 13.0%.
13. The alloy of embodiment 1 wherein, by weight:
   the combined content of rhenium, tungsten, and tantalum is 9.0% to 16.5%.
14. The alloy of embodiment 13 wherein, by weight:
   the combined content of rhenium, tungsten, and tantalum is 10.0% to 15.5%.
15. The alloy of embodiment 1 further comprising, by weight: yttrium, lanthanum, and/or cerium up to 0.05% combined.
16. The alloy of embodiment 1 having one to-all of:
   an average 1500F/90ksi salt rupture life of at least 450 hours; and
   an average 1500F/100 ksi salt rupture life of at least 150 hours;
   an average 1800F/36 ksi air rupture life of at least 150 hours; and
   an average 1850F/38 ksi air rupture life of at least 40 hours.
17. The alloy of embodiment 1 having one-to-all of:
   an average 1500F/90ksi salt rupture life of at least 300 hours; and
   an average 1500F/100 ksi salt rupture life of at least 100 hours;
   an average 1800F/36 ksi air rupture life of at least 140 hours; and
   an average 1850F/38 ksi air rupture life of at least 38 hours.
18. The alloy of embodiment 1 in single-crystal (SX) form.
19. A turbine blade comprising a substrate formed of the alloy of embodiment 1.
20. The turbine blade of embodiment 19 comprising:
   an attachment root;
   an airfoil extending from a proximal end to a tip; and
   a platform between the airfoil and the attachment root.
21. The turbine blade of embodiment 20 further comprising:
   a thermal barrier coating atop the substrate at least along the airfoil.
22. The turbine blade of embodiment 21 wherein:
   the thermal barrier coating is not along the root and platform underside.
23. The alloy of embodiment 1, heat treated by a method comprising:
   a solution heat treat for a period of at least 4.0 hours; and
   after the solution heat treat, an intermediate heat treatment at 1950F to 2075F for 3.5 hours to 4.5 hours followed by a final aging precipitation heat at a temperature of 1575F to 1675F for a period of 4.0 hours to 32.0 hours.
24. The alloy of embodiment 23 wherein:
   the precipitation heat is at a temperature of 1575F to 1675F for a period of 8.0 hours to 32.0 hours.
25. The alloy of embodiment 23 wherein:
   the solution heat treat is at least 20F over solvus.
26. A method for using the alloy of embodiment 1, the method comprising:
   a solution heat treat for a period of at least 4.0 hours; and
   after the solution heat treat, a final aging precipitation heat at a temperature of 1575F to 1675F for a period of 4.0 hours to 32.0 hours.
27. The method of embodiment 26 wherein:
   the method is effective to improve rupture performance in salt environments relative to a pure precipitation heat treat.
28. The method of embodiment 26 wherein:
   the method is effective to improve rupture performance in salt environments relative to a solution heat treat of 2.0 hours or less followed by precipitation heat treat otherwise under like conditions.

## Claims

1. An alloy comprising, by weight:
nickel (Ni) as a largest constituent;
6.8% to 7.3% chromium;
1.9% to 2.3% molybdenum;
9.8% to 10.2% cobalt;
5.3% to 5.6% aluminum;
2.9% to 3.2% rhenium;
6.8% to 7.3% tungsten;
0.09% to 0.13% hafnium;
0.03% carbon;
between 0% and 0.01% boron;
between 0% and 0.001% yttrium; and
6.0% to 6.5% tantalum.

2. The alloy of claim 1 comprising, by weight:
nickel (Ni) as a largest constituent;
6.9% to 7.2% chromium;
2.0% to 2.2% molybdenum;
9.9% to 10.1% cobalt;
5.3% to 5.5% aluminum;
2.9% to 3.1% rhenium;
6.9% to 7.1% tungsten;
0.10% to 0.12% hafnium;
0.03% carbon;
between 0% and 0.01% boron;
between 0% and 0.001% yttrium; and
6.1% to 6.3% tantalum.

3. The alloy of claim 2 comprising, by weight:
nickel (Ni) as a largest constituent;
7.1% chromium;
2.1% molybdenum;
10.0% cobalt;
5.4% aluminum;
3.0% rhenium;
7.0% tungsten;
0.11% hafnium;
0.03% carbon;
between 0% and 0.01% boron;
between 0% and 0.001% yttrium; and
6.2% tantalum.

4. The alloy of any preceding claim in single-crystal (SX) form.

5. The alloy of any preceding claim, heat treated by a method comprising:
a solution heat treat for a period of at least 4.0 hours, preferably wherein the solution heat treat is at least 20°F over solvus; and
after the solution heat treat, an intermediate heat treatment at 1975°F for 4.0 hours followed by a final aging precipitation heat at a temperature of 1500°F for a period of 8.0 hours.

6. The alloy of any preceding claim having an average 1500F/90ksi salt rupture life of at least 430.2 hours.

7. A turbine blade comprising a substrate formed of the alloy of any preceding claim.

8. The turbine blade of claim 7, wherein the turbine blade comprises:
an attachment root;
an airfoil extending from a proximal end to a tip; and
a platform between the airfoil and the attachment root.

9. The turbine blade of claim 8 further comprising:
a thermal barrier coating atop the substrate at least along the airfoil.

10. The turbine blade of claim 9, wherein the thermal barrier coating is not along the root and platform underside.

11. A method for using the alloy of any one of claims 1 to 6, the method comprising:
a solution heat treat for a period of at least 4.0 hours; and
after the solution heat treat, an intermediate heat treatment at 1975°F for 4.0 hours followed by a final aging precipitation heat treatment at a temperature of 1500°F for a period of 8.0 hours.

12. The method of claim 11 wherein:
the method is effective to improve rupture performance in salt environments relative to a pure precipitation heat treat.

13. The method of claim 11 or 12, wherein:
the method is effective to improve rupture performance relative to a solution heat treat of 2.0 hours or less followed by precipitation heat treat otherwise under like conditions.
